# FASCICULE DE BREVET EUROPEEN

(11) **EP 3 671 232 B1**
(45) Date de publication et mention de la délivrance du brevet: **30.09.2026**
(21) Numéro de dépôt: 19217047.0
(22) Date de dépôt: 17.12.2019
(51) Int. Cl.: G01R 23/165

(54) **DISPOSITIF D'ANALYSE D'UN SIGNAL ET PROCÉDÉ ASSOCIÉ**
SIGNALANALYSEVORRICHTUNG UND ENTSPRECHENDES VERFAHREN
DEVICE FOR ANALYSING A SIGNAL AND ASSOCIATED METHOD

(30) Priorité: 19.12.2018 FR 1873339
(43) Date de publication de la demande: 24.06.2020
(73) Titulaire: Thales, 92400 Courbevoie (FR)
(72) Inventeur: FORMONT, Stéphane, 78851 ELANCOURT CEDEX (FR); HODE, Jean-Michel, 33700 MERIGNAC (FR)
(74) Mandataire: Lavoix

(56) Documents cités:
- EP-A1- 2 515 127
- EP-A2- 0 981 054
- CN-A- 107 976 572
- US-A- 5 162 723
- US-A1- 2013 090 874
- WALT KESTER: "SECTION 5 UNDERSAMPLING APPLICATIONS Fundamentals of Undersampling Increasing ADC SFDR and ENOB using External SHAs Use of Dither Signals to Increase ADC Dynamic Range Effect of ADC Linearity and Resolution on SFDR and Noise in Digital Spectral Analysis Applications Future Trends in Undersampling AD", PRACTICAL ANALOG DESIGN TECHNIQUES, 1 January 1995 (1995-01-01), XP055414835, Retrieved from the Internet <URL:http://sss-mag.com/pdf/ad5.pdf> [retrieved on 20171011]
- DAPONTE PASQUALE ET AL: "Analog-to-information converters in the wideband rf measurement for aerospace applications: current situation and perspectives", IEEE INSTRUMENTATION & MEASUREMENT MAGAZINE, IEEE SERVICE CENTER, PISCATAWAY, NJ, US, vol. 20, no. 1, 1 February 2017 (2017-02-01), pages 20 - 28, XP011641825, ISSN: 1094-6969, [retrieved on 20170224], DOI: 10.1109/MIM.2017.7864545
- NGUYEN LAP-LUAT ET AL: "Digital compensation of lowpass filters imperfection in the Modulated Wideband Converter compressed sensing scheme for radio frequency monitoring", SIGNAL PROCESSING, ELSEVIER SCIENCE PUBLISHERS B.V. AMSTERDAM, NL, vol. 152, 15 June 2018 (2018-06-15), pages 292 - 310, XP085475709, ISSN: 0165-1684, DOI: 10.1016/J.SIGPRO.2018.06.011

## Description

La présente invention concerne un dispositif d'analyse d'un signal. L'invention se rapporte également à une plate-forme comportant un tel dispositif et à un procédé d'analyse.

Pour certaines applications, il est souhaitable de réaliser des analyses spectrales en temps réel ou en temps court sur des signaux large bande, typiquement présentant un spectre supérieur ou égal à 10 GHz, afin de caractériser leurs propriétés intrinsèques, comme le nombre de signaux, la fréquence ou leur durée.

Pour cela, il est connu de réaliser la numérisation du signal en utilisant un échantillonneur-bloqueur large bande fonctionnant à une fréquence d'échantillonnage donnée associée à un dispositif de conversion analogique-numérique. Pour des signaux large bande, les performances des échantillonneurs-bloqueurs connus ne permettent pas d'à la fois respecter le critère de Shannon et d'obtenir une vitesse de calcul suffisante pour un traitement temps réel. Il en résulte que des repliements de spectre ont lieu et rendent impossible la distinction de certains signaux, en particulier pour déterminer leur fréquence.

Du fait de ces repliements, il a été proposé d'échantillonner plusieurs fois en parallèle le signal mais à des fréquences d'échantillonnage différentes puis d'appliquer des transformées de Fourier sur des fenêtres temporelles identiques comportant les signaux échantillonnés. La comparaison des spectres obtenus permet de retrouver le signal.

De fait que les résolutions fréquentielles des analyses spectrales sont toutes différentes, la levée d'ambiguïté entre les signaux au niveau de l'étape de comparaison est complexe et peut être erronée. La fiabilisation de ces problèmes suppose un procédé relativement lent.

Il existe donc un besoin pour un dispositif permettant de déterminer les caractéristiques d'un signal large bande qui soit plus rapide.

Pour cela, il est proposé un dispositif d'analyse de signal, le dispositif d'analyse comportant N voies de traitement d'un signal, chaque voie de traitement comprenant un dispositif d'échantillonnage fonctionnant à une fréquence d'échantillonnage, un convertisseur analogique-numérique fonctionnant à une fréquence de conversion, la fréquence de conversion étant strictement supérieure à la plus grande des fréquences d'échantillonnage, un filtre intercalé entre le dispositif d'échantillonnage et le convertisseur analogique-numérique, le filtre étant un filtre présentant une fréquence de coupure, la fréquence de coupure de chaque filtre étant supérieure ou égale à la moitié de la plus grande des fréquences d'échantillonnage de l'ensemble des voies de traitement, et un calculateur propre à analyser le signal de sortie du convertisseur analogique-numérique.

Suivant des modes de réalisation particuliers, le dispositif d'analyse comprend une ou plusieurs des caractéristiques suivantes, prise(s) isolément ou suivant toutes les combinaisons techniquement possibles :
- sur chaque voie de traitement, l'écart entre la fréquence de conversion et la fréquence d'échantillonnage est strictement supérieur à 10%.
- des composants sont identiques entre les voies de traitements, les composants identiques étant choisis parmi le filtre et le convertisseur analogique-numérique.
- le dispositif d'analyse est adapté pour un signal présentant une bande spectrale supérieure ou égale à 10 GHz.
- chaque filtre est un filtre passe-bande ou un filtre passe-bas.
- le dispositif d'analyse comporte, en outre, un récepteur propre à recevoir le signal et un séparateur relié au récepteur et comportant N ports de sortie, le séparateur séparant le signal que le récepteur est propre à recevoir sur les N ports de sorties, N étant un nombre entier supérieur ou égal à 1, chaque voie de traitement étant reliée à un port de sortie respectif.

En outre, la présente description se rapporte également à une plate-forme, notamment aéronef, comportant un dispositif d'analyse tel que précédemment décrit.

La présente description décrit aussi un procédé d'analyse d'un signal par un dispositif d'analyse comportant N voies de traitement d'un signal, le procédé comprenant, sur chaque voie de traitement, au moins une étape d'échantillonnage à une fréquence d'échantillonnage par un dispositif d'échantillonnage, pour obtenir un signal échantillonné, de filtrage du signal échantillonné par un filtre présentant une fréquence de coupure, la fréquence de coupure de chaque filtre étant supérieure ou égale à la moitié de la plus grande des fréquences d'échantillonnage de l'ensemble des voies de traitement, pour obtenir un signal filtré, de conversion du signal filtré par un convertisseur analogique-numérique fonctionnant à une fréquence de conversion, la fréquence de conversion étant strictement supérieure à la plus grande des fréquences d'échantillonnage, pour obtenir un signal converti, et d'analyse du signal converti par un calculateur.

D'autres caractéristiques et avantages de l'invention apparaîtront à la lecture de la description qui suit de modes de réalisation de l'invention, donnée à titre d'exemple uniquement et en référence aux dessins qui sont :
- [Fig 1] figure 1, une représentation schématique d'une plate-forme comprenant un dispositif d'analyse d'un signal ;

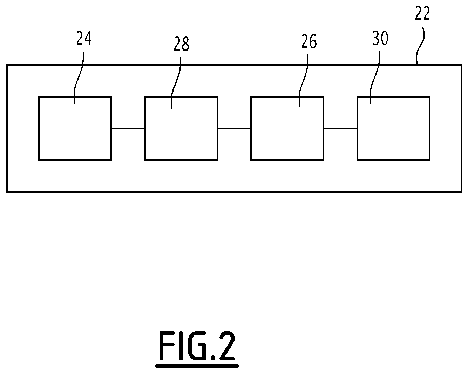

- [Fig 2] figure 2, une vue schématique du dispositif d'analyse de la figure 1 ;
- [Fig 3] figure 3, un exemple de spectre que le dispositif d'analyse est adapté à obtenir ;
- [Fig 4] figure 4, des exemples de spectres obtenus à l'issue d'une première étape d'une mise en œuvre d'un exemple de procédé d'analyse ;
- [Fig 5] figure 5, des exemples de spectres obtenus à l'issue d'une deuxième étape d'une mise en œuvre d'un exemple de procédé d'analyse ;
- [Fig 6] figure 6, des exemples de spectres obtenus à l'issue d'une troisième étape d'une mise en œuvre d'un exemple de procédé d'analyse ;
- [Fig 7] figure 7, des exemples de spectres obtenus à l'issue d'une quatrième étape d'une mise en œuvre d'un exemple de procédé d'analyse, et
- [Fig 8] figure 8, des exemples de spectres obtenus à l'issue d'une cinquième étape d'une mise en œuvre d'un exemple de procédé d'analyse.

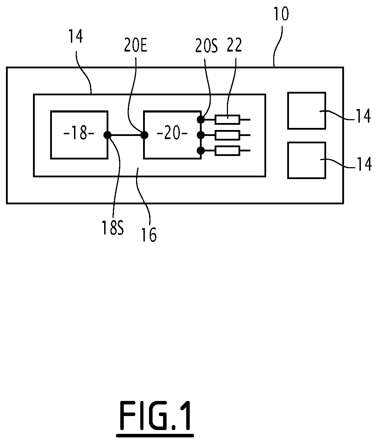

Une plate-forme 10 est représentée schématiquement sur la figure 1.

La plate-forme 10 est, par exemple, un véhicule.

Selon l'exemple proposé, la plate-forme est un aéronef.

La plate-forme 10 comporte des systèmes 12 fonctionnant en temps réel assurant le fonctionnement de la plate-forme 10.

Trois systèmes en temps réel 14 sont représentés sur la figure 1.

Pour la suite, il est supposé qu'un des systèmes en temps réel est un dispositif d'analyse de signal 16.

Le dispositif d'analyse 16 est propre à analyser les propriétés d'un signal incident.

Le dispositif d'analyse 16 est adapté pour un signal présentant une bande spectrale supérieure ou égale à 10 GigaHertz (GHz).

Un signal présentant une bande spectrale supérieure ou égale à 10 GHz est considéré comme un signal large bande.

Le dispositif d'analyse 16 comporte un récepteur 18, un séparateur 20 et des voies de traitement 22.

Le récepteur 18 est propre à recevoir le signal à analyser

Le séparateur 20 comporte un port d'entrée 20E et N ports de sortie 20S.

N est un nombre entier supérieur ou égal à 2.

Par exemple, le nombre N est supérieur à 4.

Le séparateur 20 est relié au récepteur 18. Plus précisément, le port d'entrée 20E du séparateur 20 est relié à la sortie 18S du récepteur 18.

Le séparateur 20 est propre à séparer le signal que le récepteur 18 est propre à recevoir sur les N ports de sorties 20S.

Chaque voie de traitement 22 est reliée à un port de sortie 20S respectif du séparateur 20.

Le nombre de voies de traitement 22 est donc égal à N.

Chaque voie de traitement 22 est propre à traiter un signal.

Chaque voie de traitement 22 comprend plusieurs composants qui sont : un dispositif d'échantillonnage 24, un convertisseur analogique-numérique 26, un filtre 28 et un calculateur 30.

Dans le cas proposé, le dispositif d'échantillonnage 24 est un échantillonneur-bloqueur 24.

Dans l'exemple décrit, il est supposé que le filtre 28 et le convertisseur analogique-numérique 26 sont identiques entre les voies de traitements.

Par « composants identiques » dans ce contexte, il est entendu que les deux composants présentent les mêmes caractéristiques aux dispersions de fabrication près.

Pour un filtre 28 formé par des éléments électroniques, les dispersions proviennent, par exemple, d'une part des précisions intrinsèques des différents éléments employés. Similairement, pour un convertisseur analogique-numérique 26, les dispersions sont liées aux dispersions de fabrication, aux dispersions sur les éléments parasites, et aux dispersions sur les câblages.

L'échantillonneur-bloqueur 24 est propre à fonctionner à une fréquence d'échantillonnage propre à la voie de traitement 22 considérée.

Ainsi, la fréquence d'échantillonnage de l'échantillonneur-bloqueur 24 de la voie de traitement 22 présentant l'indice i est noté Fsᵢ avec l'indice i qui est un nombre entier compris entre 1 et N.

Dans l'exemple décrit, l'échantillonneur-bloqueur 24 est adapté à traiter un signal présentant une excursion en fréquence de plusieurs dizaines de GigaHertz.

En particulier, l'échantillonneur-bloqueur 24 présente un temps d'acquisition du signal faible au regard de la fréquence maximale du signal à analyser.

Le filtre 28 est intercalé entre l'échantillonneur-bloqueur 24 et le convertisseur analogique-numérique 26.

Le filtre 28 est propre à filtrer un signal incident provenant de l'échantillonneur-bloqueur 24.

Le filtre 28 est un filtre analogique.

Le filtre 28 présente une fréquence de coupure Fc.

La fréquence de coupure Fc de chaque filtre 28 est supérieure ou égale à la moitié de la plus grande des fréquences d'échantillonnage Fsᵢ de l'ensemble des voies de traitement 22.

Selon l'exemple décrit, le filtre 28 est un filtre passe-bande.

En variante, le filtre 28 est un filtre passe-bas.

Il est également à noter que chaque filtre 28 présente une atténuation à une fréquence comprise entre Fs₀/2 et Fs₀ compatible avec la dynamique recherchée après analyse spectrale.

La fréquence Fs₀ est la fréquence de conversion commune à laquelle chaque convertisseur analogique-numérique 26 est propre à fonctionner à une fréquence de conversion.

La fréquence de conversion Fs₀ est strictement supérieure à la fréquence d'échantillonnage Fsᵢ.

De préférence, l'écart entre la fréquence de conversion Fs₀ et la fréquence d'échantillonnage Fsᵢ est strictement supérieur à 10%, ce qui permet de diminuer les contraintes d'architecture sur le filtre 28.

Un tel effet est encore plus favorisé si l'écart entre la fréquence de conversion Fs₀ et la fréquence d'échantillonnage Fsᵢ est strictement supérieur à 20%, voire strictement supérieur à 50%.

En effet, plus l'écart entre la fréquence de conversion Fs₀ et la fréquence d'échantillonnage Fsᵢ est faible et plus il devient possible d'utiliser sur chaque voie de traitement 22 des filtres 28 présentant des pentes de réjection avec une faible raideur. Chaque filtre 28 peut alors présenter un ordre plus faible, ce qui permet d'envisager des filtres 28 plus simples. En particulier, le filtre 28 peut comporter moins de composants ou des composants présentant des performances moindres.

Le calculateur 30 est propre à analyser le signal numérisé du convertisseur analogique-numérique 26.

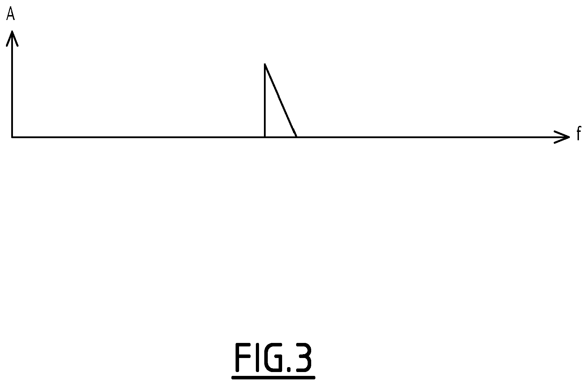

Le fonctionnement du dispositif d'analyse 16 est maintenant décrit en référence à un exemple de mise en œuvre d'un procédé d'analyse d'un signal ainsi qu'aux figures 3 à 8.

Lors d'une étape de réception, le récepteur reçoit le signal à analyser.

A titre d'illustration, la mise en œuvre du procédé est illustrée pour un signal à spectre limité. L'extension à un signal de spectre plus large est immédiate mais plus délicate à représenter.

Le signal à analyser est le signal représenté sur la figure 3.

Puis, le signal à analyser est séparé lors d'une étape de séparation sur les N voies de traitement 22 à l'aide du séparateur 20.

Sur chaque voie de traitement 22, une pluralité d'opérations sont effectuées et sont maintenant détaillées.

Dans une première opération, le signal est échantillonné par échantillonneur-bloqueur 24 à la fréquence d'échantillonnage Fsᵢ de l'échantillonneur-bloqueur 24.

Cette opération s'interprète comme une opération de périodisation du spectre du signal avec une période liée à la fréquence d'échantillonnage Fsᵢ.

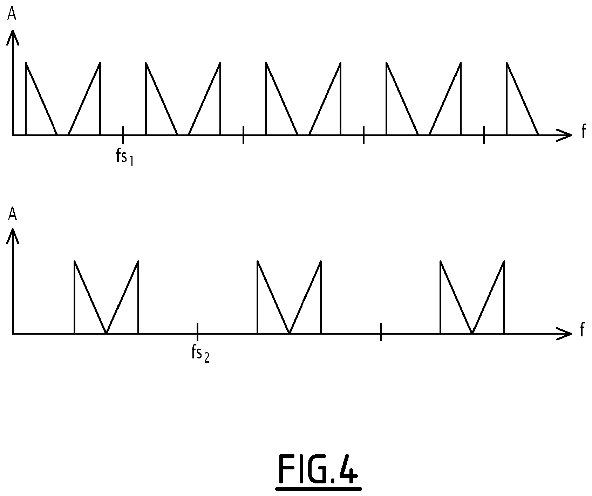

Le spectre du signal obtenu après mise en œuvre de cette opération est décrit sur la figure 4 pour le cas de la première voie de traitement 22 (fréquence d'échantillonnage Fs₁) et de la deuxième voie de traitement 22 (fréquence d'échantillonnage Fs₂).

Puis, lors d'une deuxième opération, le filtre 28 filtre le signal échantillonné.

Du fait que la fréquence de coupure Fc de chaque filtre 28 est supérieure à la moitié de la fréquence d'échantillonnage Fsᵢ, le filtre 28 sélectionne uniquement la partie du spectre qui a été repliée sur la bande de base.

Ensuite, chaque convertisseur analogique-numérique 26 numérise chaque signal à la fréquence de conversion Fs₀.

Les opérations décrites après cette opération sont mises en œuvre par le calculateur 30.

Une opération de transformée de Fourier rapide est alors appliquée sur le signal converti.

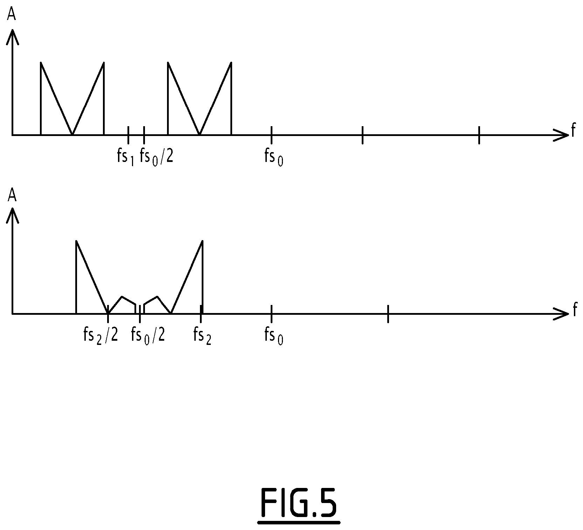

Les signaux obtenus après analyse spectrale sont représentés à la figure 5 pour la première voie de traitement 22 et la deuxième voie de traitement.

La connaissance de la fréquence d'échantillonnage Fsᵢ de chaque voie de traitement 22 permet de ne garder que les parties utiles des spectres obtenus à l'étape précédente.

La partie utile du spectre sur la première voie est le spectre compris entre 0 et la moitié de la première fréquence d'échantillonnage Fs₁.

Plus généralement, la partie utile du spectre sur la i-ième voie est le spectre compris entre 0 et la moitié de la i-ième fréquence d'échantillonnage Fsᵢ.

Puis, chaque spectre est complété de valeurs nulles pour compléter le spectre jusqu'à la fréquence de conversion Fs₀.

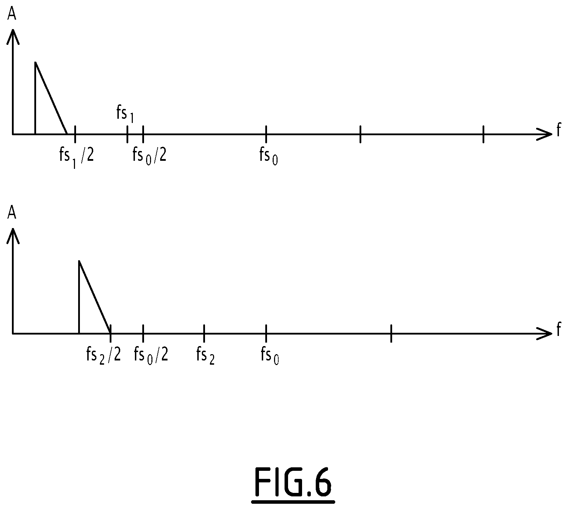

Les spectres ainsi obtenus pour la première voie de traitement 22 et la deuxième voie de traitement 22 sont visibles sur la figure 6.

Le signal obtenu précédemment sert de motif de base pour reconstituer le spectre entre Fsᵢ/2 et Fsᵢ en symétrisant le motif de base. Il est ainsi obtenu un motif à répéter.

Puis le motif à répéter est ensuite répété pour reconstituer le signal.

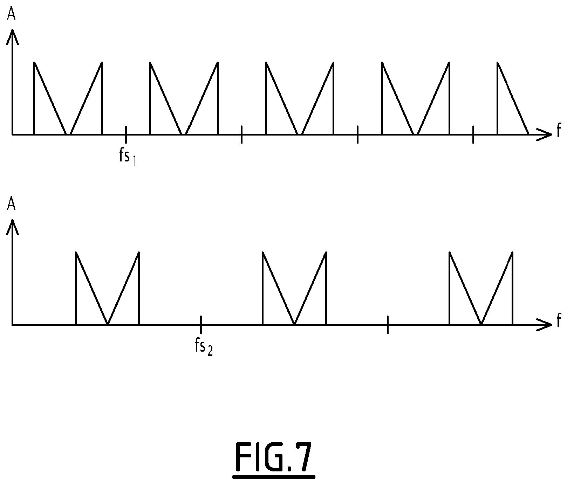

Les signaux reconstitués ainsi obtenus pour la première voie de traitement 22 et la deuxième voie de traitement 22 sont visibles sur la figure 7.

Une opération de recherche des zones de fréquences où les signaux reconstitués sont superposés est alors mise en œuvre.

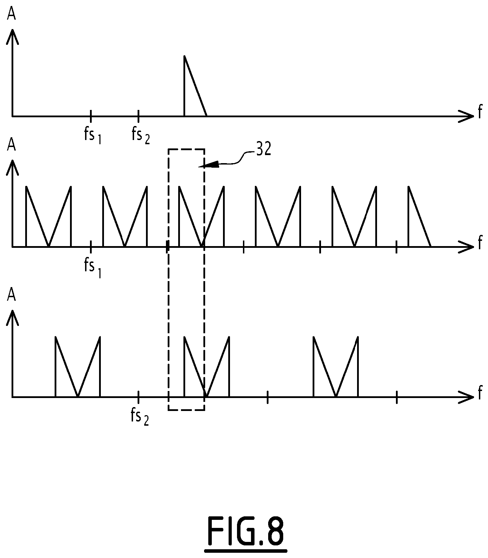

L'opération est schématisée sur la figure 8 qui comporte trois graphes, le premier étant celui de la figure 3 et les deux suivants ceux de la figure 7.

Dans le cas illustré, la zone de superposition se trouve dans le rectangle 32 en traits pointillés. Le signal dans le rectangle 32 correspond au signal à analyser qui était le signal cherché.

Le procédé qui vient d'être décrit permet d'effectuer une analyse portant sur une pluralité de signaux.

En outre, le procédé est aisément reconfigurable dans la mesure où il suffit de changer les fréquences d'échantillonnage Fsᵢ pour parvenir à un fonctionnement différent du procédé.

Aussi, le dispositif d'analyse 16 est un dispositif reconfigurable d'analyse spectrale numérique de signaux large bande.

Le procédé est aisément implémentable puisque que les opérations utilisées sont des opérations non complexes à optimiser. Par exemple, la transformée de Fourier rapide est aisément optimisable du point de vue calculatoire.

En effet, le procédé est mis en œuvre sur un dispositif d'analyse 16 permettant de simplifier les traitements numériques qui sont accomplis par la suite en particulier en découplant les fréquences d'échantillonnage Fsᵢ multiples utilisées pour numériser le signal et la fréquence employée pour acquérir les signaux qui sont ensuite analysés en utilisant des transformées de Fourier rapides.

Le procédé n'impose pas le nombre de points sur lesquels les opérations sont mises en œuvre sur chaque voie de traitement 22. Le nombre de voies de traitement 22 peut donc être optimisé en fonction de l'application souhaitée pour le procédé.

De plus, il est à noter que le procédé est mis en œuvre en conservant une largeur des canaux spectraux identiques entre les voies de traitement 22.

D'autres variantes du dispositif d'analyse 16 sont envisageables. En particulier, le signal à analyser peut être unique (il est alors divisé par N), ou peut provenir de différentes antennes, et ce dispositif d'analyse 16 peut être couplé à d'autres systèmes d'analyse de signal.

## Revendications

1. Dispositif d'analyse de signal (16), le dispositif d'analyse (16) comportant N voies de traitement (22) d'un signal, N est un nombre entier supérieur ou égal à 2, chaque voie de traitement (22) comprenant :
- un dispositif d'échantillonnage (24) fonctionnant à une fréquence d'échantillonnage (Fsᵢ),
- un convertisseur analogique-numérique (26) fonctionnant à une fréquence de conversion (Fs₀), la fréquence de conversion (Fs₀) étant strictement supérieure à la plus grande des fréquences d'échantillonnage (Fsᵢ),
- un filtre (28) intercalé entre le dispositif d'échantillonnage (24) et le convertisseur analogique-numérique (26), le filtre (28) étant un filtre présentant une fréquence de coupure (Fc), la fréquence de coupure (Fc) de chaque filtre (28) étant supérieure ou égale à la moitié de la plus grande des fréquences d'échantillonnage (Fsᵢ) de l'ensemble des voies de traitement (22), et
- un calculateur propre à analyser le signal de sortie du convertisseur analogique-numérique (26).

2. Dispositif d'analyse selon la revendication 1, dans lequel, sur chaque voie de traitement (22), l'écart entre la fréquence de conversion (Fs₀) et la fréquence d'échantillonnage (Fsᵢ) est strictement supérieur à 10%.

3. Dispositif d'analyse selon la revendication 1 ou 2, dans lequel des composants sont identiques entre les voies de traitements (22), les composants identiques étant choisis parmi le filtre (28) et le convertisseur analogique-numérique (26).

4. Dispositif d'analyse selon l'une quelconque des revendications 1 à 3, dans lequel le dispositif d'analyse (16) est adapté pour un signal présentant une bande spectrale supérieure ou égale à 10 GHz.

5. Dispositif d'analyse selon l'une quelconque des revendications 1 à 4, dans lequel chaque filtre (28) est un filtre passe-bande ou un filtre passe-bas.

6. Dispositif d'analyse selon l'une quelconque des revendications 1 à 5, dans lequel le dispositif d'analyse (16) comporte, en outre :
- un récepteur (18) propre à recevoir le signal,
- un séparateur (20) relié au récepteur (18) et comportant N ports de sortie (20S), le séparateur (20) séparant le signal que le récepteur (18) est propre à recevoir sur les N ports de sorties (20S),
chaque voie de traitement (22) étant reliée à un port de sortie (20S) respectif.

7. Plate-forme (10), notamment aéronef, comportant un dispositif d'analyse (16) selon l'une quelconque des revendications 1 à 6.

8. Procédé d'analyse d'un signal par un dispositif d'analyse (16) comportant N voies de traitement (22) d'un signal, N est un nombre entier supérieur ou égal à 2, le procédé comprenant, sur chaque voie de traitement (22), au moins une étape de :
- échantillonnage à une fréquence d'échantillonnage (Fsᵢ) par un dispositif d'échantillonnage (24), pour obtenir un signal échantillonné,
- filtrage du signal échantillonné par un filtre (28) présentant une fréquence de coupure (Fc), la fréquence de coupure (Fc) de chaque filtre (28) étant supérieure ou égale à la moitié de la plus grande des fréquences d'échantillonnage (Fsᵢ) de l'ensemble des voies de traitement (22), pour obtenir un signal filtré,
- conversion du signal filtré par un convertisseur analogique-numérique (26) fonctionnant à une fréquence de conversion (Fs₀), la fréquence de conversion (Fs₀) étant strictement supérieure à la plus grande des fréquences d'échantillonnage (Fsᵢ), pour obtenir un signal converti et
- analyse du signal converti par un calculateur (30).

## Patentansprüche

1. Signalanalysevorrichtung (16), wobei die Analysevorrichtung (16) N Verarbeitungskanäle (22) eines Signals umfasst, N eine ganze Zahl größer oder gleich 2 ist, wobei jeder Verarbeitungskanal (22) Folgendes umfasst:
- eine Abtastvorrichtung (24), die mit einer Abtastfrequenz (Fsᵢ) arbeitet,
- einen Analog-Digital-Wandler (26), der mit einer Umwandlungsfrequenz (Fs₀) arbeitet, wobei die Umwandlungsfrequenz (Fs₀) strikt größer als die größte der Abtastfrequenzen (Fsᵢ) ist,
- ein Filter (28), das zwischen der Abtastvorrichtung (24) und dem Analog-Digital-Wandler (26) zwischengeschaltet ist, wobei das Filter (28) ein Filter ist, das eine Grenzfrequenz (Fc) aufweist, wobei die Grenzfrequenz (Fc) jedes Filters (28) größer oder gleich der Hälfte der größten der Abtastfrequenzen (Fsᵢ) der Gesamtheit der Verarbeitungskanäle (22) ist, und
- einen Rechner, der dazu geeignet ist, das Ausgangssignal des Analog-DigitalWandlers (26) zu analysieren.

2. Analysevorrichtung nach Anspruch 1, wobei, auf jedem Verarbeitungskanal (22), der Abstand zwischen der Umwandlungsfrequenz (Fs₀) und der Abtastfrequenz (Fsᵢ) strikt größer als 10% ist.

3. Analysevorrichtung nach Anspruch 1 oder 2, wobei Komponenten zwischen den Verarbeitungskanälen (22) identisch sind, wobei die identischen Komponenten aus dem Filter (28) und dem Analog-Digital-Wandler (26) ausgewählt sind.

4. Analysevorrichtung nach einem beliebigen der Ansprüche 1 bis 3, wobei die Analysevorrichtung (16) für ein Signal geeignet ist, das ein Spektralband größer oder gleich 10 GHz aufweist.

5. Analysevorrichtung nach einem beliebigen der Ansprüche 1 bis 4, wobei jedes Filter (28) ein Bandpassfilter oder ein Tiefpassfilter ist.

6. Analysevorrichtung nach einem beliebigen der Ansprüche 1 bis 5, wobei die Analysevorrichtung (16) ferner Folgendes umfasst:
- einen Empfänger (18), der dazu geeignet ist, das Signal zu empfangen,
- einen Trenner (20), der mit dem Empfänger (18) verbunden ist und N Ausgangsports (20S) umfasst, wobei der Trenner (20) das Signal, für dessen Empfang der Empfänger (18) geeignet ist, auf die N Ausgangsports (20S) trennt,
wobei jeder Verarbeitungskanal (22) mit einem jeweiligen Ausgangsport (20S) verbunden ist.

7. Plattform (10), insbesondere Luftfahrzeug, umfassend eine Analysevorrichtung (16) nach einem beliebigen der Ansprüche 1 bis 6.

8. Verfahren zur Analyse eines Signals durch eine Analysevorrichtung (16), die N Verarbeitungskanäle (22) eines Signals umfasst, N eine ganze Zahl größer oder gleich 2 ist, wobei das Verfahren, auf jedem Verarbeitungskanal (22), mindestens einen Schritt umfasst des:
- Abtastens mit einer Abtastfrequenz (Fsᵢ) durch eine Abtastvorrichtung (24), um ein abgetastetes Signal zu erhalten,
- Filterns des abgetasteten Signals durch ein Filter (28), das eine Grenzfrequenz (Fc) aufweist, wobei die Grenzfrequenz (Fc) jedes Filters (28) größer oder gleich der Hälfte der größten der Abtastfrequenzen (Fsᵢ) der Gesamtheit der Verarbeitungskanäle (22) ist, um ein gefiltertes Signal zu erhalten,
- Umwandelns des gefilterten Signals durch einen Analog-Digital-Wandler (26), der mit einer Umwandlungsfrequenz (Fs₀) arbeitet, wobei die Umwandlungsfrequenz (Fs₀) strikt größer als die größte der Abtastfrequenzen (Fsᵢ) ist, um ein umgewandeltes Signal zu erhalten, und
- Analysierens des umgewandelten Signals durch einen Rechner (30).

## Claims

1. Device for analyzing a signal (16), the analysis device (16) having N signal processing channels (22), N being an integer superior or equal to 2, each processing channel (22) comprising:
- a sampling device (24) operating at a sampling frequency (Fsᵢ),
- an analog-to-digital converter (26) operating at a conversion frequency (Fs₀), the conversion frequency (Fs₀) being strictly greater than the sampling frequency (Fsᵢ),
- a filter (28) interposed between the sampling device (24) and the analog-to-digital converter (26), the filter (28) being a filter having a cutoff frequency (Fc), the cutoff frequency (Fc) of each filter (28) is greater than or equal to half of the largest sampling frequency (Fsᵢ) of the set of processing channels (22), and
- a calculator adapted to analyze the output signal of the analog-to-digital converter (26).

2. Analysis device according to claim 1, wherein, on each processing channel (22), the difference between the conversion frequency (Fs₀) and the sampling frequency (Fsᵢ) is strictly greater than 10%.

3. Analysis device according to claim 1 or 2, wherein components are identical between the processing channels (22), the identical components being selected from the filter (28) and the analog-to-digital converter (26).

4. Analysis device according to any one of claims 1 to 3, wherein the analysis device (16) is designed for a signal having a spectral band greater than or equal to 10 GHz.

5. Analysis device according to any one of claims 1 to 4, wherein each filter (28) is a band-pass filter or a low-pass filter.

6. Analysis device according to any one of claims 1 to 5, wherein the analysis device (16) further comprises:
- a receiver (18) adapted to receive the signal,
- a separator (20) connected to the receiver (18) and having N output ports (20S), wherein the separator (20) separates the signal that the receiver (18) is designed to receive at the N output ports (20S),
each processing channel (22) being connected to a respective output port (20S).

7. Platform (10), in particular an aircraft, comprising an analysis device (16) according to any one of claims 1 to 6.

8. Method of analyzing a signal by an analysis device (16) comprising N signal processing channels (22), N being an integer superior or equal to 2, the method comprising, on each processing channel (22), at least one step of:
- sampling at a sampling frequency (Fsᵢ) by a sampling device (24), to obtain a sampled signal,
- filtering the signal sampled by a filter (28) having a cutoff frequency (Fc), the cutoff frequency (Fc) of each filter (28) is greater than or equal to half of the largest sampling frequency (Fsᵢ) of the set of processing channels (22), to obtain a filtered signal,
- conversion of the filtered signal by an analog-to-digital converter (26) operating at a conversion frequency (Fs₀), the conversion frequency (Fs₀) being strictly greater than the sampling frequency (Fsᵢ), to obtain a converted signal and
- analysis of the signal converted by a calculator (30).
